(19)

Europäisches
Patentamt
European
Patent Office
Office européen
des brevets

(11) **EP 1 676 302 B1**

(12) **EUROPEAN PATENT SPECIFICATION**

(45) Date of publication and mention
of the grant of the patent:
**17.12.2008 Bulletin 2008/51**

(51) Int Cl.:
***H01L 21/3065*** *(2006.01)*

(21) Application number: **04817803.2**

(22) Date of filing: **19.10.2004**

(86) International application number:
**PCT/US2004/034803**

(87) International publication number:
**WO 2005/045904 (19.05.2005 Gazette 2005/20)**

(54) **NOTCH-FREE ETCHING OF HIGH ASPECT SOI STRUCTURES USING A TIME DIVISION MULTIPLEX PROCESS AND RF BIAS MODULATION**

KERBENFREIES ÄTZEN VON SOI-STRUKTUREN MIT HOHEM SEITENVERHÄLTNIS DURCH VERWENDUNG EINES ZEITLICH GEMULTIPLEXTEN PROZESSES UND HF-VORMODULATION

GRAVURE CHIMIQUE SANS ENTAILLAGE DE STRUCTURES SILICIUM-SUR-ISOLANT PAR UN TRAITEMENT A MULTIPLEXAGE PAR REPARTITION DANS LE TEMPS ET MODULATION DE LA POLARISATION DE RADIO-FREQUENCES

(84) Designated Contracting States:
**AT BE BG CH CY CZ DE DK EE ES FI FR GB GR HU IE IT LI LU MC NL PL PT RO SE SI SK TR**

(30) Priority: **21.10.2003 US 512933 P**
**18.10.2004 US 968823**

(43) Date of publication of application:
**05.07.2006 Bulletin 2006/27**

(73) Proprietor: **Unaxis USA Inc.**
**St. Petersburg, FL 33718 (US)**

(72) Inventors:
• **SRINIVASAN, Sunil**
**Tampa, FL 33617 (US)**

• **JOHNSON, David**
**Palm Harbor, FL 34683 (US)**
• **WESTERMAN, Russell**
**Largo, FL 33773 (US)**

(74) Representative: **Hedley, Nicholas James Matthew et al**
**Kilburn & Strode**
**20 Red Lion Street**
**London**
**WC1R 4PJ (GB)**

(56) References cited:
**WO-A-00/67306           US-A- 4 795 529**
**US-A- 6 110 287          US-A1- 2002 066 537**
**US-B1- 6 187 685         US-B1- 6 214 162**

**Description**

**Field of the Invention**

The present invention relates generally to the manufacture of silicon based micro-electro-mechanical-systems. More particularly, the present invention relates to the manufacture of high aspect ratio silicon structures using alternating deposition and etching steps with a modulated RF bias.

**Background of the Invention**

The fabrication of high aspect ratio features in silicon is used extensively in the manufacture of microelectromechanical (MEMS) devices. Such feature frequently extend completely through the silicon wafer and may require etching in excess of $500\mu m$ into the silicon substrate. Even "shallow" features require etch depths up to $30\mu m$ with feature widths as small as $1\mu m$, requiring the definition of structures with aspect ratios (depth/width) in excess of 30:1. To ensure manufacturability, these processes must operate at high etch rates to maintain reasonable throughputs.

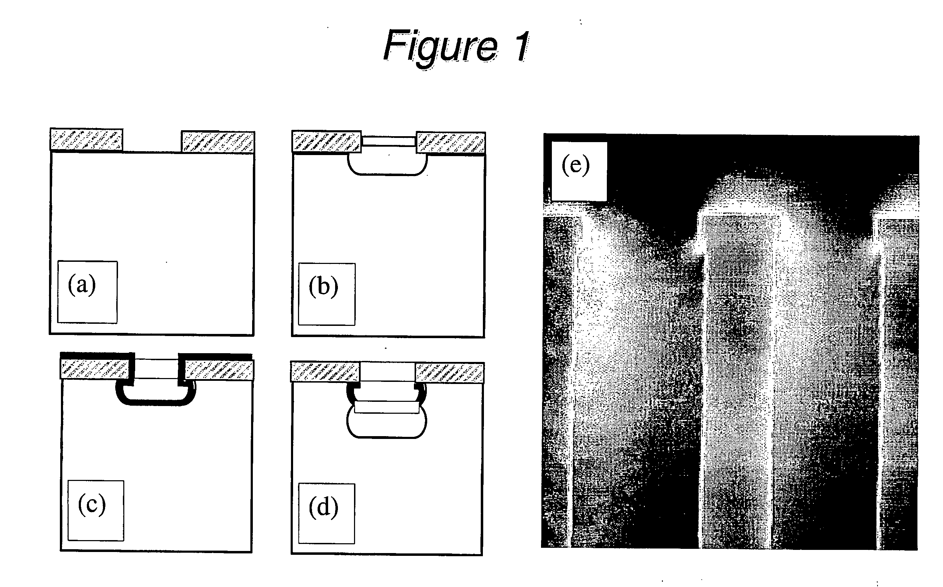

Conventional, single step, plasma etch processes cannot simultaneously meet these needs, and alternating deposition/etching processes have been developed. Such processes are frequently referred to as Time Division Multiplexed (TDM) processes, which more generally consist of at least one group containing two or more process steps, where the group(s) is periodically repeated. These processes (see for example U.S. Patent 4,985,114 and U.S. Patent 5,501,893) are typically carried out in a reactor configured with a high-density plasma source, such as an Inductively Coupled Plasma (ICP), in conjunction with a radio frequency (RF) biased substrate electrode. The most common process gases used in the TDM etch process for silicon are sulfur hexafluoride and octofluorocyclobutane. Sulfur hexafluoride ($SF_6$) is typically used as the etch gas and octofluorocyclobutane ($C_4F_8$) as the deposition gas. During the etch step (*Figure 1(b)*), $SF_6$ facilitates spontaneous and isotropic etching of silicon (Si); in the deposition step (*Figure 1(c)*), $C_4F_8$ facilitates protective polymer deposition onto the sidewalls as well as the bottom of etched structures. Upon energetic and directional ion bombardment, which is present in etch steps, the polymer film coated in the bottom of etched structures from the previous deposition step will be removed to expose silicon surface for further etching. The polymer film on the sidewall will remain because it is not subjected to direct ion bombardment, inhibiting lateral etching. The TDM process cyclically alternates between etch and deposition process steps enabling high aspect ratio structures to be defined into a masked silicon substrate (*Figures 1(d) & 1(e)*). Using the TDM approach allows high aspect ratio features to be defined into silicon substrates at high Si etch rates. A complex TDM process may incorporate more than one etch step, and more than one deposition step that are cyclically repeated.

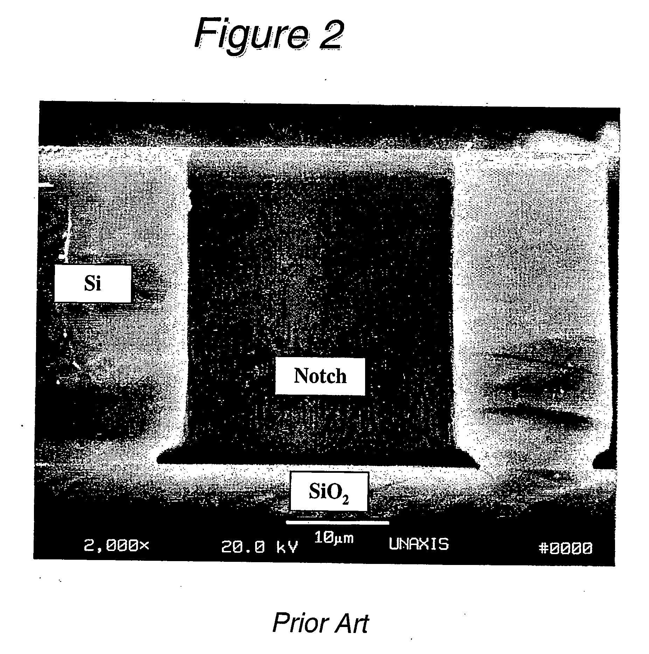

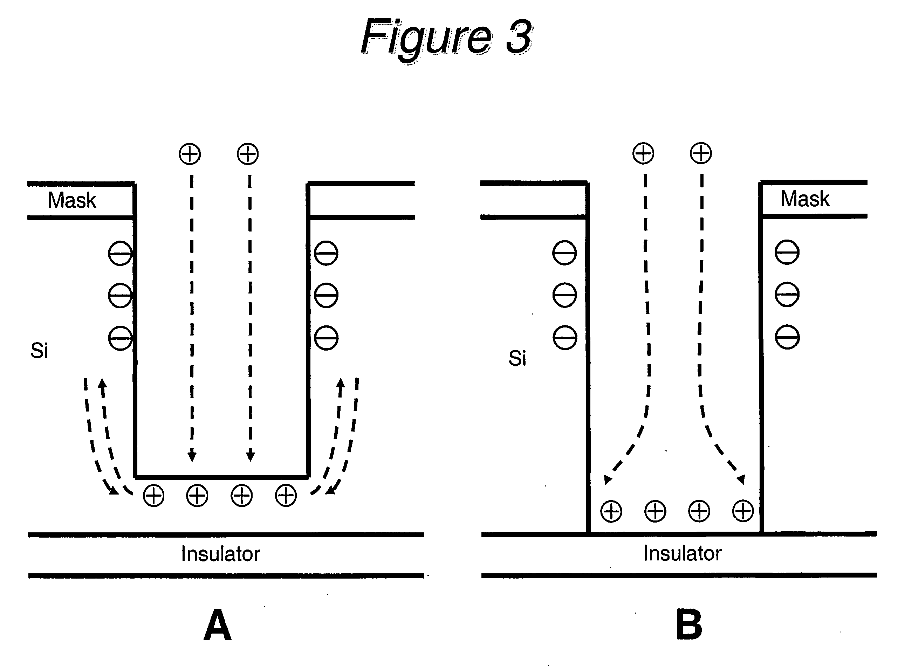

Certain MEMS devices require that the silicon substrate be etched down to a buried insulating layer such as silicon dioxide ($SiO_2$), which acts as an etch stop (Silicon On Insulator, SOI structure), or which is required for functionality of the final device. When such structures are etched using a TDM process a well-documented phenomenon, commonly referred to as "notching", occurs. This is evidenced as a severe undercutting of the silicon, localized at the silicon/insulator interface (*Figure 2*). It is generally understood that this is caused by electrical charging effects during the etching. Because of the different angular distributions of ions and electrons in the plasma, ions tend to accumulate at the bottom of the feature, and electrons at the top. During the bulk etch, because the silicon substrate is sufficiently conductive, current flow within the substrate prevents any charge separation (*Figure 3A*). However, when the etch reaches the silicon/insulator interface, the insulator is exposed and the conductive current path is broken, which allows charge separation to occur. The resultant electric field is strong enough to bend the trajectories of arriving ions into the feature sidewall where lateral etching (notching) occurs (*Figure 3B*). Note, for a full discussion see KP Giapis, Fundamentals of Plasma Process-Induced Charging and Damage in Handbook of Advanced Plasma Processing Techniques, RJ Shul and SJ Pearton, Eds, Springer 2000.

The notching effect is more prevalent in high density plasma, because the ion density and therefore the charging effect due to the ions, is greater. The effect can therefore be reduced by the use of a low density plasma (conventional reactive ion etching (RIE)) which is employed only after the insulator has been exposed (Donohue et al. U.S. Patent 6,071,822). The major drawback of such an approach is the low etch rate attainable, which is a serious shortcoming when features with various depths must be etched. This is a necessary consequence of etching devices with various feature sizes, which will etch to different depths due to Aspect Ratio Dependent Etching (ARDE).

Two groups have taught the use of TDM processes and novel RF bias configurations (U.S. Patent 4,579,623 and U.S. Patent 4,795,529). Neither of these groups contemplate modulating the RF bias frequency in conjunction with a TDM process.

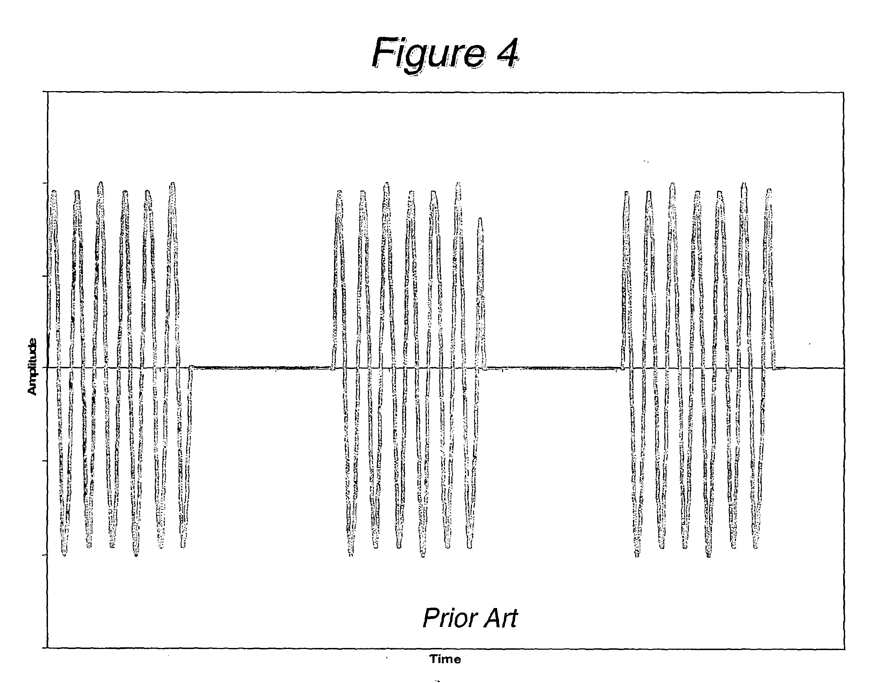

The use of a low frequency (below 4 MHz) RF substrate bias with a TDM deposition / etch process has also been described by Hopkins et al. (U.S. Patent 6,187,685). The authors describe the use of amplitude-pulsed RF bias (*Figure 4*) in a TDM process. Hopkins does not teach modulating the frequency of the RF bias.

U.S. Patents 5,983,828, 6,253,704 and 6,395,641 by Savas teach the use of a pulsed ICP to alleviate surface charging and subsequent notching. However, none of the Patents by Savas teach the modulation of the frequency of the RF bias to eliminate or reduce notching.

Ogino et al. (U.S. Patent 6,471,821) teach frequency modulation of the RF bias power as an effective means of reducing charging of the wafer surfaces during a plasma etch process. Ogino et al. consider frequency modulation between two discrete frequency values as well as continuous frequency modulation. Ogino et al. do not consider the application of frequency modulated RF bias to a TDM process.

Arai et al. (U.S. Patent 6,110,287) also teach frequency modulation of the RF bias power in order to relax charge formation on the substrate during an etch process. Amplitude modulation of the frequency modulated RF bias power is also disclosed, including the case of pulsing between some power level and zero. Arai et al. do not consider the application of frequency and/or amplitude modulated RF bias to a TDM process.

Otsubo et al. (U.S. Patent 4,808,258) also teach frequency or amplitude modulation of the RF bias power to improve etch rate and selectivity of plasma processes. Frequency modulation between 1 MHz and 13.56 MHz is disclosed. Amplitude modulation of the RF bias between two discrete levels is also discussed. Otsubo et al. do not consider the application of frequency and/or amplitude modulated RF bias to a TDM process.

Therefore, there is a need for an alternating deposition and etch process that reduces and/or eliminates notching.

Nothing in the prior art provides the benefits attendant with the present invention.

Therefore, it is an object of the present invention to provide an improvement which overcomes the inadequacies of the prior art devices and which is a significant contribution to the advancement of the semiconductor processing art.

## Summary of the Invention

For the purpose of summarizing this invention, this invention comprises an improved method and an apparatus for deep silicon trench etching using an alternating cyclical etch process or time division multiplexed (TDM) process to eliminate the notching observed on SOI structures.

According to the present invention, there is provided a method for etching a feature in a substrate, e.g. a semiconductor substrate, during an alternating deposition and etch process comprising the steps of placing the substrate in a vacuum chamber; subjecting the substrate to the alternating deposition and etch process; generating a plasma in at least one step of the alternating deposition and etch process; applying a frequency modulated RF bias to the substrate; and removing the substrate from the vacuum chamber.

Preferably, the method comprises the steps of: placing the substrate on a substrate support in a vacuum chamber, said substrate support being a lower electrode; an etching step comprising introducing a first process gas into the vacuum chamber, generating a first plasma from said first process gas to etch the substrate; a passivation step comprising introducing a second process gas into the vacuum chamber, generating a second plasma from said second process gas to deposit a passivation layer on the substrate; alternatingly repeating the etching step and the passivation step; applying a modulated bias to the substrate though said lower electrodes and removing the substrate from the vacuum chamber.

According to another aspect of the present invention, there is provided an apparatus for etching a feature in a substrate comprising: a vacuum chamber; at least one gas supply source for supplying at least one process gas into said vacuum chamber; an exhaust in communication with said vacuum chamber; a lower electrode positioned within said vacuum chamber; a substrate holder connected to said lower electrode; a plasma source, said plasma source being adapted to generate a plasma from said process gas within said vacuum chamber; a control system, said control system being adapted to change the plasma conditions of the generated plasma to alternate between etching the substrate and depositing a passivation layer on the substrate; and a modulation signal generator, said modulation signal generator being adapted to provide a frequency modulated RF bias to said lower electrode.

Beneficial results can be attained by applying the disclosed invention, as described or as modified within the scope of the disclosure.

In most plasma vacuum treatment processes (etching or deposition), the main parameters that can be altered to optimize etching or deposition performance are: the flow rates of the various gases, the working pressure, the electromagnetic power coupled to the plasma to generate it, and the energy with which the substrate is bombarded. As a general rule, to optimize a deposition or etching process, the flow rates of the various gases, the electromagnetic power coupled to the plasma and the substrate bombardment energy are optimized at precise and constant values throughout the treatment. Whereas, the present invention provides for an improved method apparatus utilizing a modulated RF frequency to reduce or eliminate notching during an alternating deposition and etch process.

A feature of the present invention is to provide a method for etching a feature in a substrate. The substrate can be a semiconductor substrate such as Silicon, Gallium Arsenide or any known semiconductor, including compound semiconductors *e.g.*, Group II and Group VI compounds and Group III and Group V compounds. The substrate may also be a conductor or a dielectric material such as glass or quartz. The method comprising the steps of placing the substrate on a substrate support in a vacuum chamber, generating a high density plasma using a first source of RF energy. The substrate support is a lower electrode to which is connected a second source of RF energy which provides a bias voltage to the substrate. An alternatingly and repeating process is performed on the substrate. One part of the process is an etching step which is carried out by introducing a first process gas, such as Sulfur hexafluoride, into the vacuum chamber. A first plasma is generated from the first process gas to etch the substrate. The other part of the alternatingly and repeating process is a passivation step which is carried out by introducing a second process gas, such as octofluorocyclobutane into the vacuum chamber. A second plasma is generated from the second process gas to deposit a passivation layer on the substrate. The passivation layer consists of a polymer or a fluorocarbon polymer, or can be silicon, carbon, nitride or any other known passivating materials that can be deposited via a plasma. During the alternatingly and repeating process, one or more process parameters can vary over time within the etching step or the passivation step. In addition, during the alternatingly and repeating process, one or more process parameters can vary over time from etching step to etching step or from passivation step to passivation step. During the alternatingly and repeating process a modulated bias is applied to the substrate through the lower electrode. The bias can be voltage controlled. The bias is frequency modulated and it can be applied at or below the ion transit frequency. The bias can be switched between two distinct frequencies such that the switching is defined by a switching rate and a switching duty cycle. The switching rate can be less than about 10kHz and the switching duty cycle less than 50%. The RF bias frequency can be continuously modulated and be defined by a mathematical function such as exp(k*sin(t)). The RF bias can additionally be amplitude modulated. Further, the RF bias can be phase modulated or wave shaped modulated. Finally, upon completion of the etch process, the substrate is removed from the vacuum chamber.

Still yet another feature of the present invention is to provide an apparatus for etching a feature in a substrate. The apparatus comprising a vacuum chamber having at least one gas supply source for supplying at least one process gas into the vacuum chamber and an exhaust in communication with the vacuum chamber. A lower electrode is positioned within the vacuum chamber for applying a bias to the substrate that is placed upon a substrate holder that is connected to the lower electrode. A plasma source generates a plasma within the vacuum chamber. The plasma that is generated is controlled through a control system, depending on the plasma, alternately etching the substrate and depositing a passivation layer on the substrate. A modulation signal generator provides a modulated bias to the lower electrode. The bias is powered by RF, it is frequency modulated and it can be provided at or below the ion transit frequency. In addition, the frequency of the RF bias can be phase modulated or wave shaped modulated in conjunction with the alternating etching and deposition process.

The foregoing has outlined rather broadly the more pertinent and important features of the present invention in order that the detailed description of the invention that follows may be better understood so that the present contribution to the art can be more fully appreciated. Additional features of the invention will be described hereinafter which form the subject of the claims of the invention. It should be appreciated by those skilled in the art that the conception and the specific embodiment disclosed may be readily utilized as a basis for modifying or designing other structures for carrying out the same purposes of the present invention. It should also be realized by those skilled in the art that such equivalent constructions do not depart from the scope of the invention as set forth in the appended claims.

### Brief Description of the Drawings

The invention will be described further, by way of example, with reference to the accompanying drawings in which:

Figures 1(a-d) is a pictorial example of one type of the TDM process for deep silicon etching,
Figure 1(e) is a typical scanning electron microscopy photograph of an etch performed using a TDM process for deep silicon etchings
Figure 2 is a scanning electron microscopy photograph of an etch performed using a TDM process for deep silicon etching showing the notch formation at the surface of the substrate;
Figures 3A and 3B are a pictorial of charge buildup at the surface of the semiconductor substrate during a typical TDM process;
Figure 4 is a graph of amplitude versus time showing a pulsed amplitude RF bias in a TDM process;
Figure 5 is a graph of amplitude versus time showing frequency switched modulation using two discrete frequencies for a TDM process;
Figure 6 is a graph of amplitude versus time showing continuous frequency modulation for a TDM process;
Figure 7 is a schematic of a plasma reactor configured for providing a modulated bias to a substrate;
Figure 8 is a schematic of a plasma reactor configured for providing a modulated RF bias in conjunction with a modulated high density source to a substrate for a TDM process; and
Figure 9 is a scanning electron microscopy photograph of an etch performed using a modulated bias as taught in the present invention for a TDM process for deep silicon etching showing no notch formation at the surface of the substrate.

Similar reference characters refer to similar parts throughout the several views of the drawings.

### Detailed Description of the Invention

We disclose an improved method and apparatus for reducing, or eliminating, the notching observed when etching SOI structures, by using an alternating deposition/etch process in conjunction with a modulated RF bias.

The present invention provides a method and apparatus for improved etching of silicon on insulator (SOI) structures through the use of a frequency modulated RF bias. Additionally, the RF bias can be phase modulated, or wave shaped modulated in conjunction with a TDM process.

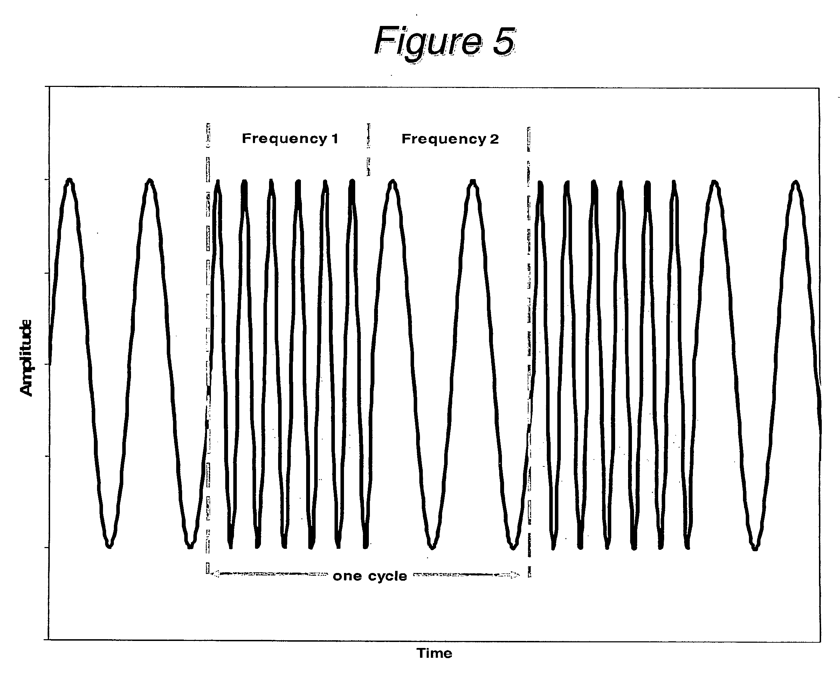

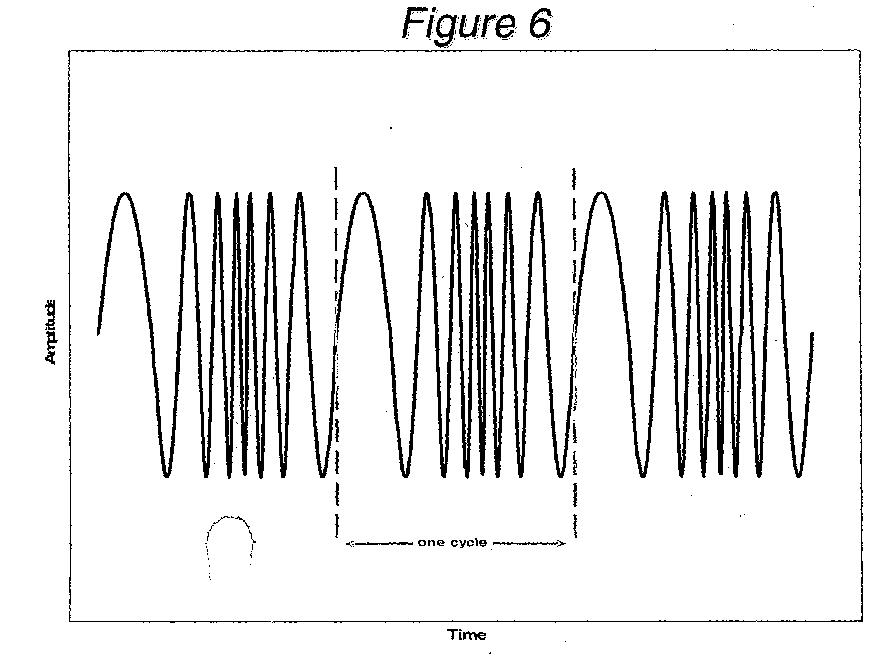

By frequency modulation of the RF bias, for the present invention, it is meant that bias voltage applied to the cathode is changed between at least two frequencies, either discretely switched (*Figure 5*) or continuously modulated (*Figure 6*) during the time division multiplex process.

By wave shaped modulation it is meant that the bias voltage waveform to the cathode is changed between at least two shapes, either discretely or continuously modulated. Such waveform shapes may be, for example, a sine wave and a square-wave or any arbitrary waveforms.

By phase modulated bias it is meant that the bias waveform is changed between at least two states, either discretely or continuously modulated, where the difference between the two states is a phase relationship.

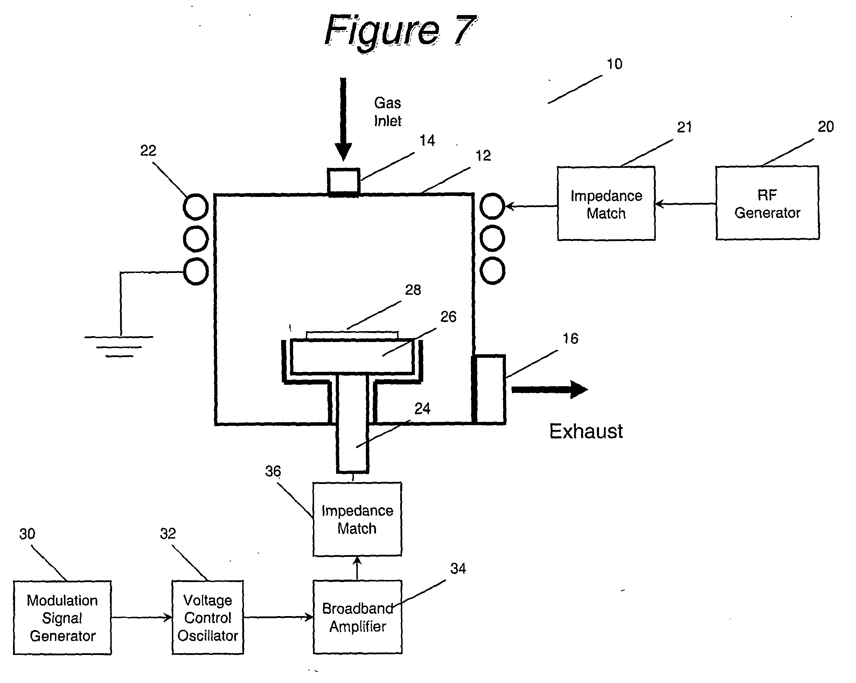

A reactor 10 configured for frequency modulated RF bias is shown in *Figure 7*. The reactor 10 shown comprises a vacuum chamber 12, a gas inlet 14, an exhaust 16, an inductively coupled plasma power source (RF generator) 20 that is connected to a first impedance matching network 21 that provides power to a coil 22, a lower electrode 24 and a substrate holder 26 for a substrate 28. Provided, as part of the reactor 10, is a modulation signal generator 30 that is connected to a voltage control oscillator 32 that is connected to a broadband amplifier 34 that is connected to a second impedance matching network 36 that supplies power to the lower electrode 24. It should be noted that applying a modulated RF bias is not limited to this configuration and one skilled in the art will appreciate that alternate approaches are possible. Thus the waveform can be digitally synthesized and applied to the broadband amplifier 34 using an arbitrary waveform generator. The RF Bias frequency is preferentially modulated during the etch sub-cycle of the deposition/etch process, since this is when the notching primarily occurs. However, the RF bias frequency can also be modulated through both deposition and etch sub-cycles.

The duration of the RF Bias high-frequency state should be short enough that charge build-up on the feature surfaces has not reached a steady state, or is at a steady state for only a short period of time. This time scale is typically on the order of a few microseconds to a few milliseconds. The duration of the low-frequency RF bias state should be long enough that charge bleed off can occur, but not so long that reduced etch rates are produced. The low-frequency duration should also be of the order of a few microseconds to a few milliseconds. In the case of switching the RF bias frequency between two discrete values, the duty cycle, as defined by the high frequency duration divided by the total modulation cycle period, should be in the range of 5-90%, preferably 10-50%

The RF bias frequency for the high-frequency state should be below the ion transit frequency to allow ions to follow the voltage on the cathode over time.

The ion transit frequency, $\omega_{pi}$, is described by:

$$\omega_{pi} = ( e^2 n_o / \varepsilon_o M )^{1/2}$$

Where

    e - charge on an electron
    $n_o$ - ion density
    $\varepsilon_o$ - permittivity in a vacuum
    M - mass of the ion

For a typical high density plasma etcher for semiconductor applications, the ion transit frequency is approximately 2 MHz. Notching performance is improved by using a high frequency state in the range of 50kHz to 2MHz. A preferred embodiment uses a high frequency state in the range of 50kHz to 300kHz and a low frequency state in the range of 1kHz to 10kHz which significantly improves notching performance.

In a time division multiplex process, the etch step proceeds in two stages. During the 1st stage of the etch step, the passivating film from the previous deposition step is removed from the horizontal surfaces. This passivation removal process typically follows an ion assisted etch mechanism with the polymer removal rate being a function of the ion energy. Ion energy (and passivation removal rate) increases with increasing bias voltage. Thus it is important to control the magnitude of the bias voltage. Once the passivation layer has been cleared, the exposed Si then proceeds to etch by a primarily chemical etch mechanism.

As described above, the amplitude of the modulated bias is maintained constant as the frequency is changed. It is also possible to additionally change the amplitude of the waveform. This may be done in such a manner that the amplitude is high when the frequency is high or alternately such that the amplitude is low when the frequency is high. As with the frequency, the amplitude can be switched discreetly between two levels or continuously varied between two levels.

It is important to note for all the systems and methods described above that the TDM finish etch method can be implemented as a single sequence or multi-sequence process. A sequence refers to a group of deposition and/or etch steps. In the single sequence implementation, modulated RF bias is used during the entire process.

In the multi-sequence implementation, the first sequence can be any suitable method (TDM or conventional plasma etch process) that results in the required etch profile and etch rate, but which is terminated before the underlying insulator is exposed. The RF bias need only be modulated for the period when the insulator film is exposed, since this is when the maximum benefit from charge reduction and, therefore, notch reduction is expected. The etch is completed using a modulated RF bias "finish" etch to avoid notching at the silicon/insulator interface.

Etch endpoint detection methods, such as laser reflectance and optical emission spectroscopy (OES), are helpful in determining when the insulating film has been exposed.

For all of the modulated RF bias systems and methods described above, the ICP power can be maintained "on" continuously during the etch cycle, or it to can be pulsed. This pulsing can be either in phase with the RF bias modulation (*i.e.*, the ICP is "on" when the RF bias frequency or amplitude is high), can be out of phase with the RF Bias modulation (*i.e.*, ICP is "on" when the RF bias frequency or amplitude is low) or can bear some other phase relationship to the RF bias (*i.e.*, can be phase shifted).

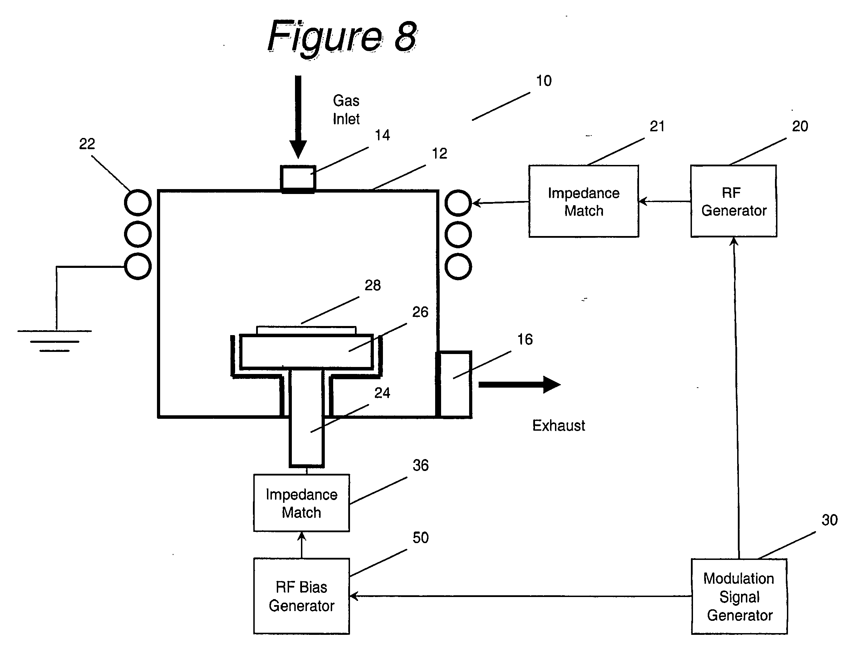

A reactor 10 configured for a modulated RF bias in conjunction with a modulated high density source is shown in *Figure 8.* The reactor 10 shown comprises a vacuum chamber 12, a gas inlet 14, an exhaust 16, an inductively coupled plasma power source (RF generator) 20 that is connected to a first impedance matching network 21 that provides power to a coil 22, a lower electrode 24 and a substrate holder 26 for a substrate 28. Provided, as part of the reactor 10, is a modulation signal generator 30 that is connected to both the RF Generator 20 and an RF Bias Generator 50 that is connected to a second impedance matching network 36 that supplies power to the lower electrode 24. The high density source can be operated at a preferred frequency of 2 MHz or can be at higher frequencies (*e.g.,* 13.56, 27, 40, 60, 100 MHz, 2.45 GHz) or at lower frequencies (*e.g.*, 50 kHz - 2 MHz). While the examples below were performed using an ICP source to generate the high density plasma, other sources such as ECR, helicon, TCP, etc. could also be used.

## Example

The result of etching an SOI structure using a standard TDM etch process (prior art) with an approximate 2 minute over-etch (sufficient to etch other smaller structures) is shown in the cross section of *Figure 2.* The notch at the silicon-insulator interface is evident, and extends ~ 3μm into the silicon. Other features with widths of ~ 4μm were undercut to an extent that they were no longer attached to the substrate.

The preferred embodiment is a significant improvement over the prior art in terms of notch performance. The reactor is a commercially available Unaxis VLR modified according to the requirements of the present invention. *Figure 7* represents the preferred embodiment of the present invention, namely, frequency modulation of the RF bias for improved notch performance. The modulated RF bias is amplified and is applied through an impedance matching network to the electrode.

The test pattern used to characterize the notch performance has ~ 45μm of Si before a buried oxide layer of 1μm. The oxide layer acts as an etch stop layer. The lines are 4μm wide and spaces range from the smallest opening of 2.5μm to the largest opening of 100μm. The resist is ~ 1.7μm thick and the percentage of exposed to unexposed Si on a 6" wafer is ~ 15%. The finish etch process recipe with ideal notch performance corresponding to the preferred embodiment of the present invention is detailed below.

The Si etch before exposure of the oxide layer is non-critical for notch performance. The transition between the standard TDM Si etch and the TDM Si finish etch (present invention) is made using an optical emission end point technique.

**Finish Etch with Notch performance - Present invention**

|  | Deposition Step | Etch A Step | Etch B Step |
|---|---|---|---|
| **Ar - sccm** | 40 | 40 | 40 |
| **SF$_6$ - sccm** | - | 50 | 100 |
| **C$_4$F$_8$ - sccm** | 70 | - | - |
| **ICP - W** | 1100 | 1200 | 1200 |
| **Pressure-mT** | 18 | 23 | 25 |
| **RF Bias** | - | 1* | 1* |

**1\* - RF Bias modulation**

$$\text{High Frequency value / duration} - 100 \text{ kHz /} \quad 660 \text{ } \mu\text{sec}$$

$$\text{Low Frequency value / duration} - \quad 1 \text{ kHz / } 1340 \text{ } \mu\text{sec}$$

$$\text{Total time for 1 cycle} - \quad 2000 \text{ } \mu\text{sec}$$

**Results**

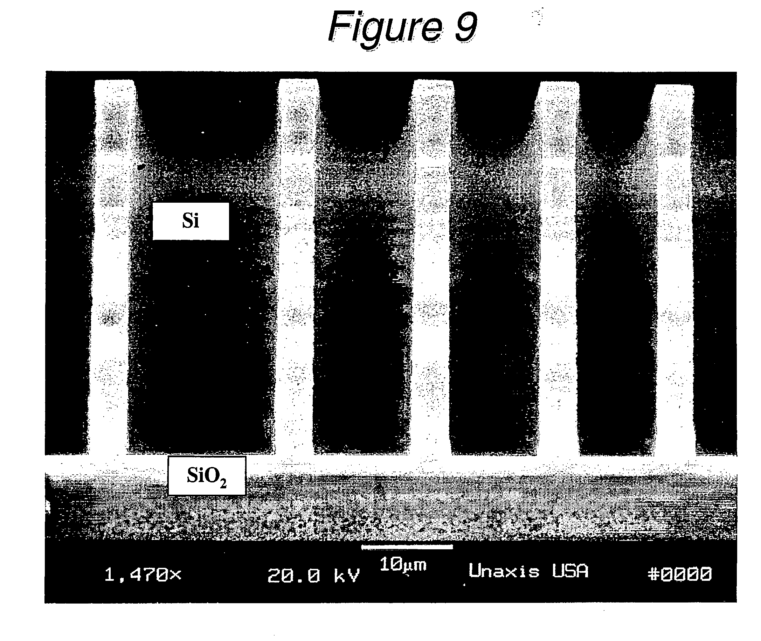

The result of etching an SOI structure using a frequency modulated TDM Si finish etch is shown in Figure 9. The over etch on the 15$\mu$m, 10$\mu$m, 9$\mu$m and 8$\mu$m (from L-R in Figure 9) is sufficient to etch the smallest feature (2.5$\mu$m opening) to the buried oxide layer. The absence of any notching at the Si-oxide interface seen in the cross section is a significant improvement over the prior art.

The present disclosure includes that contained in the appended claims, as well as that of the foregoing description. Although this invention has been described in its preferred form with a certain degree of particularity, it is understood that the present disclosure of the preferred form has been made only by way of example and that numerous changes in the details of construction and the combination and arrangement of parts may be resorted to without departing from the scope of the invention.

**Claims**

1. A method for etching a feature in a substrate (28), e.g. a semiconductor substrate, during an alternating deposition and etch process comprising the steps of:

   placing the substrate in a vacuum chamber (12);
   subjecting the substrate to the alternating deposition and etch process;
   generating a plasma in at least one step of the alternating deposition and etch process;
   applying a frequency modulated RF bias to the substrate; and
   removing the substrate from the vacuum chamber.

2. The method of claim 1 wherein said application of modulated bias is voltage controlled.

3. The method of claim 1 wherein said bias frequency is applied to the substrate below the ion transit frequency.

4. The method of claim 1 wherein at least one RF frequency is below the ion transit frequency.

5. The method of claim 1 wherein the frequency of the RF bias is switched between at least two values and optionally wherein the frequency of the RF bias is switched between a low frequency state of less than about 10 kHz and a high frequency state of about 100kHz.

6. The method of claim 1 wherein the duty cycle is less than about 50%.

7. The method of claim 1 wherein said RF bias is continuously frequency modulated, or is amplitude modulated or is phase modulated or is wave shaped modulated.

8. An apparatus for etching a feature in a substrate (28) comprising:

    a vacuum chamber (12);
    at least one gas supply source (14) for supplying at least one process gas into said vacuum chamber;
    an exhaust (16) in communication with said vacuum chamber;
    a lower electrode (24) positioned within said vacuum chamber;
    a substrate holder (26) connected to said lower electrode;
    a plasma source (20), said plasma source being adapted to generate a plasma from said process gas within said vacuum chamber;
    a control system , said control system being adapted to chang the plasma conditions of the generated plasma to alternate between etching the substrate and depositing a passivation layer on the substrate;
    **characterized in that**
    the apparatus further comprises a modulation signal generator (30), said modulation signal generator being adapted to provide a frequency modulated RF bias to said lower electrode.

9. The apparatus of claim 8 wherein the modulation signal generator is adapted to provide said bias frequency to the lower electrode below the ion transit frequency.

10. The apparatus of claim 8 wherein the modulation signal generator is adapted to switch the frequency of the RF bias between at least two values, e.g. wherein the frequency of the RF bias is switched between a low frequency state of about less than 10 kHz and a high frequency state of about 100kHz.

11. The apparatus of claim 8 wherein the modulation signal generator is adapted to provide an RF bias that is amplitude modulated, or is phase modulated, or is wave shaped modulated.


**Patentansprüche**

1. Verfahren zum Ätzen eines Strukturelements in ein Substrat (28), z.B. ein Halbleitersubstrat, während eines alternierenden Ablagerungs- und Ätzprozesses, mit den Schritten:

    Platzieren des Substrats in einer Vakuumkammer (12);
    Durchführen des alternierenden Ablagerungs- und Ätzprozesses am Substrat;
    Erzeugen von Plasma in zumindest einem Schritt des alternierenden Ablagerungs- und Ätzprozesses;
    Anlegen einer frequenzmodulierten HF-Vorspannung an das Substrat; und
    Entfernen des Substrats aus der Vakuumkammer.

2. Verfahren nach Anspruch 1, wobei das Anlegen der modulierten Vorspannung spannungsgesteuert erfolgt.

3. Verfahren nach Anspruch 1, wobei die Vorspannungsfrequenz an das Substrat unterhalb der Ionen-Übergangsfrequenz angelegt wird.

4. Verfahren nach Anspruch 1, wobei zumindest eine HF-Frequenz unter der Ionen-Übergangsfrequenz liegt.

5. Verfahren nach Anspruch 1, wobei die HF-Vorspannungsfrequenz zwischen zumindest zwei Werten geschaltet wird, und vorzugsweise die HF-Vorspannungsfrequenz zwischen einem Niederfrequenzstatus von weniger als 10 kHz und einem Hochfrequenzstatus von über 100 kHz geschaltet wird.

6. Verfahren nach Anspruch 1, wobei der Arbeitszyklus weniger als 50 % beträgt.

7. Verfahren nach Anspruch 1, wobei die HF-Vorspannung kontinuierlich frequenzmoduliert oder amplitudenmoduliert oder phasenmoduliert oder wellenformmoduliert ist.

8. Vorrichtung zum Ätzen eines Strukturelements in ein Substrat (28) mit:

    einer Vakuumkammer (12);
    zumindest einer Gaszufuhrquelle (14) zum Zuführen zumindest eines Prozessgases in die Vakuumkammer;
    einem Auslass (16), der mit der Vakuumkammer in Verbindung steht;
    einer unteren Elektrode (24), die in der Vakuumkammer angeordnet ist;
    einem Substrat-Halter (26), der mit der untere Elektrode verbunden ist;
    einer Plasmaquelle (20), die eingerichtet ist, um Plasma aus dem Prozessgas in der Vakuumkammer zu erzeugen;
    einem Steuersystem, das eingerichtet ist, um die Plasmabedingungen des erzeugten Plasmas zum Wechseln zwischen Ätzen des Substrats und Ablagern einer Passivierungsschicht auf dem Substrat zu ändern;

    **dadurch gekennzeichnet, dass** die Vorrichtung weiters einen Modulationssignal-Generator (30) aufweist, der eingerichtet ist, um eine frequenzmodulierte HF-Vorspannung für die untere Elektrode vorzusehen.

9. Vorrichtung nach Anspruch 8, wobei der Modulationssignal-Generator eingerichtet ist, um die Vorspannungsfrequenz für die untere Elektrode unterhalb der Ionen-Übergangsfrequenz bereitzustellen.

10. Vorrichtung nach Anspruch 8, wobei der Modulationssignal-Generator eingerichtet ist, um die HF-Vorspannungsfrequenz zwischen zumindest zwei Werten zu schalten, wobei die HF-Vorspannungsfrequenz beispielsweise zwischen einem Niederfrequenzstatus von weniger als 10 kHz und einem Hochfrequenzstatus von über 100 kHz geschaltet wird.

11. Vorrichtung nach Anspruch 8, wobei der Modulationssignal-Generator eingerichtet ist, um eine HF-Vorspannung vorzusehen, die amplitudenmoduliert oder phasenmoduliert oder wellenformmoduliert ist.

## Revendications

1. Procédé pour graver une particularité dans un substrat (28), par exemple un substrat semiconducteur, pendant un dépôt alterné et un procédé de gravure comprenant les étapes consistant à :

    placer le substrat dans une chambre sous vide (12) ;
    soumettre le substrat au dépôt alterné et au procédé de gravure ;
    générer un plasma dans au moins une étape du dépôt alterné et du procédé de gravure ;
    appliquer une déviation de RF modulée en fréquence au substrat ; et
    retirer le substrat de la chambre sous vide.

2. Procédé selon la revendication 1, dans lequel ladite application de la déviation modulée est régulée en tension.

3. Procédé selon la revendication 1, dans lequel ladite fréquence déviée est appliquée au substrat en dessous de la fréquence de transit des ions.

4. Procédé selon la revendication 1, dans lequel au moins une fréquence RF est en dessous de la fréquence de transit des ions.

5. Procédé selon la revendication 1, dans lequel la fréquence de la déviation RF est commutée entre au moins deux valeurs et facultativement dans lequel la fréquence de la déviation RF est commutée entre un état basse fréquence inférieur à environ 10 kHz et un état haute fréquence d'environ 100 kHz.

6. Procédé selon la revendication 1, dans lequel le coefficient d'utilisation est inférieur à 50%.

7. Procédé selon la revendication 1, dans lequel ladite déviation RF est modulée en fréquence, en amplitude, en phase ou modulée en forme d'onde de manière continue.

8. Appareil pour graver une particularité dans un substrat (28) comprenant :

une chambre sous vide (12) ;

au moins une source d'alimentation en gaz (14) pour alimenter au moins un gaz de procédé dans ladite chambre sous vide ;

un échappement (16) en communication avec ladite chambre sous vide ;

une électrode inférieure (24) positionnée dans ladite chambre sous vide ;

un porte-substrat (26) connecté à ladite électrode inférieure ;

une source de plasma (20), ladite source de plasma étant adaptée pour générer un plasma à partir dudit gaz de procédé dans ladite chambre sous vide ;

un système de commande, ledit système de commande étant adapté pour modifier les conditions de plasma du plasma généré pour alterner entre la gravure du substrat et le dépôt d'une couche de passivation sur le substrat ;

**caractérisé en ce que** l'appareil comprend en outre un générateur de signal de modulation (30), ledit générateur de signal de modulation étant adapté pour fournir une déviation RF modulée en fréquence à ladite électrode inférieure.

9. Appareil selon la revendication 8, dans lequel le générateur de signal de modulation est adapté pour fournir ladite fréquence déviée à l'électrode inférieure en dessous de la fréquence de transit des ions.

10. Appareil selon la revendication 8, dans lequel le générateur de signal de modulation est adapté pour commuter la fréquence de la déviation RF entre au moins deux valeurs, par exemple dans lequel la fréquence de la déviation RF est commutée entre un état basse fréquence inférieur à environ 10 kHz et un état haute fréquence d'environ 100 kHz.

11. Appareil selon la revendication 8, dans lequel le générateur de signal de modulation est adapté pour fournir une déviation RF qui est modulée en amplitude, est modulée en phase ou est modulée en forme d'onde.

Figure 1

Figure 2

Prior Art

# Figure 3

EP 1 676 302 B1

# Figure 4

Prior Art

Time

EP 1 676 302 B1

Figure 5

Figure 6

Amplitude

one cycle

Time

EP 1 676 302 B1

Figure 7

Figure 8

Figure 9

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 4985114 A
- US 5501893 A
- US 6071822 A
- US 4579623 A
- US 4795529 A
- US 6187685 B
- US 5983828 A
- US 6253704 B
- US 6395641 B, Savas
- US 6471821 B
- US 6110287 A
- US 4808258 A

### Non-patent literature cited in the description

- Handbook of Advanced Plasma Processing Techniques. Springer, 2000